# EUROPÄISCHE PATENTANMELDUNG

(11) **EP 3 654 477 A1**
(43) Veröffentlichungstag der Anmeldung: **20.05.2020**
(21) Anmeldenummer: 18206463.4
(22) Anmeldetag: 15.11.2018
(51) Int. Cl.: H02H 3/087, H03K 17/08

(54) **ELEKTRONISCHER SCHALTER MIT ÜBERSPANNUNGSSCHUTZ**

(71) Anmelder: Siemens Aktiengesellschaft, 80333 München (DE)
(72) Erfinder: Handt, Karsten, 92348 Berg (DE); Hänsel, Stefan, 91083 Baiersdorf (DE)

(57) **Zusammenfassung**

Die Erfindung betrifft einen elektronischen Schalter (1) mit mindestens einem abschaltbaren Halbleiterschalter (2,21,22). Zur Verbesserung des elektronischen Schalters (1), insbesondere bezüglich seines Abschaltverhaltens, wird vorgeschlagen, dass der elektronische Schalter (1) einen Kondensator (3) und einen Varistor (4) aufweist, wobei der Kondensator (3) und der Varistor (4) in einer ersten Reihenschaltung (10) angeordnet sind, wobei die erste Reihenschaltung (10) aus dem Kondensator (3) und dem Varistor (4) parallel zum abschaltbaren Halbleiterschalter (2,21,22) angeordnet ist. Weiter betrifft die Erfindung ein Verfahren zum Betreiben eines derartigen elektronischen Schalters (1) mit einem Schalter (5) und einem Widerstand (6), wobei vor dem Einschalten des abschaltbaren Halbleiterschalters (2,21,22) der Schalter (5) eingeschaltet wird.

## Beschreibung

Die Erfindung betrifft einen elektronischen Schalter mit mindestens einem abschaltbaren Halbleiterschalter. Weiter betrifft die Erfindung ein Verfahren zum Betreiben eines derartigen elektronischen Schalters.

Die Versorgung mit elektrischer Energie findet heutzutage in erster Linie über Wechselspannungsnetze statt. Diese haben den Vorteil, dass sich unterschiedliche Spannungsebenen mit Hilfe von Transformatoren herstellen lassen. Durch Halbleiter, die immer kostengünstiger am Markt verfügbar sind, lassen sich auch für DC Netze auf einfache Weise unterschiedliche Spannungsebenen erzeugen, so dass gerade auch die Energieversorgung über DC Netze, insbesondere innerhalb von Industrienetzen, besonders wirtschaftlich wird.

DC-Netze sollen dabei in zukünftigen Industrieanlagen Verluste reduzieren, den direkten Energieaustausch zwischen Umrichtern, Speichern und Motoren gewährleisten und eine erhöhte Robustheit erzielen. Dabei können beispielsweise kleine DC Netze mit unterschiedlichen Kabellängen zwischen den verschiedenen Lastabgängen und Einspeisungen betrieben werden. Die geringen Kabellängen führen zu sehr kleinen Längsinduktivitäten in den Zuleitungen, so dass Fehlerströme sehr steile Stromanstiege aufweisen können. Dies macht eine sehr schnelle Fehlererkennung und Abschaltung für den Fehlerfall erforderlich. Diese Forderungen können mechanische Schalter oftmals nicht erfüllen. Deshalb werden sogenannte elektronische Schalter mit Halbleiterschaltern eingeführt. Diese werden auch als Solid State Breaker bezeichnet. Diese Schalter zeichnen sich durch ein im Gegensatz zu mechanischen Schaltern besonders schnelle Schalten, typischerweise in der Größenordnung von 100ns, aus.

Der Erfindung liegt die Aufgabe zugrunde einen elektronischen Schalter hinsichtlich seines Abschaltverhaltens zu verbessern.

Diese Aufgabe wird durch einen elektronischen Schalter mit mindestens einem abschaltbaren Halbleiterschalter, einem Kondensator und einem Varistor gelöst, wobei der Kondensator und der Varistor in einer ersten Reihenschaltung angeordnet sind, wobei die erste Reihenschaltung aus dem Kondensator und dem Varistor parallel zum abschaltbaren Halbleiterschalter angeordnet ist. Ferner wird diese Aufgabe durch ein Verfahren zum Betreiben eines derartigen elektronischen Schalters mit einem Schalter und einem Widerstand gelöst, wobei vor dem Einschalten des abschaltbaren Halbleiterschalters der Schalter eingeschaltet wird.

Weitere vorteilhafte Ausgestaltungen der Erfindung sind in den abhängigen Ansprüchen angegeben.

Der Erfindung liegt die Erkenntnis zugrunde, dass sich das Schaltverhalten des elektronischen Schalters verbessern lässt, wenn parallel zum abschaltbaren Halbleiterschalter eine Reihenschaltung aus Varistor und Kondensator angeordnet ist. Diese Reihenschaltung kann den abschaltbaren Halbleiterschalter vor Spannungsspitzen, die beim Schalten entstehen, schützen und somit einen störungsfreien Betrieb gewährleisten und gleichzeitig seine Lebensdauer erhöhen.

Bei dem abschaltbaren Leistungshalbleiterschalter kann es sich um einen Schalter handeln, der einen Strom nur in eine Richtung abschalten kann. Dieser ist insbesondere für Lasten geeignet, die nicht rückspeisefähig sind und damit auch nur Strom in eine Richtung führen. Ebenso kann es sich um einen abschaltbaren Leistungshalbleiterschalter handeln, der einen Strom in beide Richtungen abschalten kann.

Der abschaltbare Halbleiterschalter ist empfindlich gegenüber Spannungsspitzen, die beim Schalten, insbesondere beim Abschalten, des Stroms auftreten. Durch die vorhandenen Induktivitäten im DC Netz, beispielswese aufgrund von parasitären Induktivitäten der Kabel, führen Stromänderungen, im Besonderen Stromunterbrechungen zu hohen Spannungen, die dann teilweise über den abschaltbaren Halbleiterschalter abfallen und diesen beschädigen oder seine Lebensdauer herabsetzen können. Durch die parallel angeordnete erste Reihenschaltung aus Varistor und Kondensator kann der abschaltbare Halbleiterschalter zuverlässig vor entstehenden Überspannungen und Spannungsspitzen geschützt werden.

Dabei wird ein Übergang vom sperrenden in den leitenden Zustand eines Schalters als Einschalten und ein Übergang vom leitenden in den sperrenden Zustand eines Schalters als Ausschalten oder Abschalten bezeichnet.

In Abhängigkeit seiner Strom-Spannungskennlinie fällt ein Teil der beim Abschalten des abschaltbaren Halbleiterschalters entstehenden Spannung über dem Varistor ab, der andere Teil über dem Kondensator. Hier kommt positiv zum Tragen, dass nunmehr die Auslegung des Varistors einfacher wird, da er nun nicht mehr die volle Sperrspannung übernehmen muss. Die Energie aus den Induktivitäten, sowohl in der Last als auch in den betreffenden Zweigen des DC Netzes wird nun auch von dem Kondensator aufgenommen. Dadurch baut sich im Kondensator eine Spannung auf, welche sich zu der Spannung des Varistors addiert. Besonders hilfreich ist dabei, dass bei sinkendem Laststrom die Kondensatorspannung steigt und die geringere Gegenspannung des Varistors kompensiert. Der Laststrom sinkt durch die aufgebrachte Gegenspannung des Kondensators nach der Gleichung u(t)= L*di/dt und wegen des Verhaltens des Kondensators mit i(t)=C*du/dt baut sich mehr und mehr eine Gegenspannung über dem Kondensator auf. Auf Jeden Fall wird dadurch eine Gegenspannung erzeugt, die größer ist als die treibende DC Spannung, da durch den Stromfluss durch den Kondensator eine Gegenspannung aufgebaut wird, die zwangsläufig und zuverlässig nach einer gewissen Zeit den Stromfluss unterbindet.

Mit anderen Worten wird eine Energie der Induktivität oder Induktivitäten, die sich im abzuschaltenden bzw. abgeschalteten Zweig befindet, von der oder den Induktivitäten auf den Kondensator übertragen, dessen Spannung dadurch ansteigt. Beim Ausschalten des abschaltbaren Halbleiterschalters entstehen aufgrund der hohen Stromänderung Spannungsspitzen. Diese führen dazu, dass der Varistor durchbricht und in den leitenden Zustand übergeht und einen Stromfluss von den Induktivitäten zum Kondensator ermöglicht. Die am Kondensator vorhandene und sich nur über das Integral des durch diesen fließenden Stroms aufbauende Spannung sowie die geringe Spannung am Varistor, der in den leitenden Zustand übergangen ist, liegt damit auch am abschaltbaren Halbleiterschalter an, der parallel zu der ersten Reihenschaltung aus Varistor und Kondensator angeordnet ist. Damit ist auch die Spannung am abschaltbaren Halbleiterschalter gering und schützt diesen zuverlässig vor Spannungsspitzen. Dies sichert seine Funktionsfähigkeit auch beim Abschalten von hohen Strömen oder hohen Induktivitäten im betreffenden abgeschalteten Zweig. Darüber hinaus erhöhen die moderaten Spannungen beim Abschalten des abschaltbaren Halbleiterschalters seine Lebensdauer.

Tritt nun ein Kurzschluss auf bei einer Last im Gleichspannungsnetz auf, kann die DC Quelle durch Abschalten des elektronischen Schalters von der Fehlerstelle abgetrennt werden. Der Strom durch die Lastinduktivitäten hat keinen Freilaufpfad, wodurch sich über dem abschaltbaren Halbleiterschalter eine Spannung aufbauen würde, welche diesen belastet oder diesen sogar zerstören kann. Das Spannungsbegrenzungsnetzwerk in Forma der ersten Reihenschaltung aus Varistor und Kondensator ist dabei nicht nur anwendbar bei dem hier schematisch dargestellten elektronischen Schalter mit abschaltbaren Halbleiterschaltern, sondern kann bei beliebig ausgeführten Gleichstromschaltern in DC Netzen eingesetzt werden.

Bei einer vorteilhaften Ausgestaltung der Erfindung weist der elektronische Schalter mindestens zwei abschaltbare Halbleiterschalter auf, wobei ein erster der zwei abschaltbaren Halbleiterschalter derart angeordnet ist, einen Strom von einem ersten Anschluss des elektronischen Schalters zu einem zweiten Anschluss des elektronischen Schalters abschalten zu können und ein zweiter der zwei abschaltbaren Halbleiterschalter derart angeordnet ist, einen Strom von dem zweiten Anschluss des elektronischen Schalters zu dem ersten Anschluss des elektronischen Schalters abschalten zu können, wobei der Kondensator als bipolarer Kondensator ausgebildet ist. Auf dem Markt befindliche abschaltbare Halbleiterschalter können meistens nur einen Strom in eine Richtung abschalten. Typische Vertreter für solche abschaltbaren Halbleiterschalter sind IGBTs oder MOSFETS. Will man bei der Verwendung solcher abschaltbaren Halbleiterschalter Ströme in beide Richtungen durch den Schalter abschalten können, so verwendet man zwei dieser abschaltbaren Halbleiterschalter. Damit lassen sich beide Polaritäten des Stroms durch den elektronischen Schalter abschalten. Die Schalter werden dabei so angeordnet, dass ein Strom von einem ersten Anschluss des elektronischen Schalters zu einem zweiten Anschluss des elektronischen Schalters durch einen ersten der beiden abschaltbaren Halbleiterschalter geführt und abgeschaltet werden kann und ein Strom von dem zweiten Anschluss des elektronischen Schalters zu dem ersten Anschluss des elektronischen Schalters durch einen zweiten der beiden abschaltbaren Halbleiterschalter geführt und abgeschaltet werden kann. Für den Fall, dass parallel zum schaltenden Element des Halbleiterschalters eine Diode angeordnet ist, die den abschaltbaren Halbleiterschalter rückwärts Leitfähigkeit, werden die beiden Halbleiterschalter in einer Reihenschaltung angeordnet. Da die schaltenden Elemente der beiden Halbleiterschalter jeweils einen Strom mit unterschiedlicher Polarität führen und abschalten können wird diese Reihenschaltung auch als antiseriell bezeichnet. Dabei sind die beiden Halbleiterschalter bezüglich Kollektor und Emitter bzw. Drain und Source Anschlüsse gegenüber gedreht. Für den Fall, dass die abschaltbaren Halbleiterschalter rückwärts nicht leitfähig sind, werden der erste und der zweite abschaltbare Halbleiterschalter in einer Parallelschaltung angeordnet, bei dem der erste abschaltbaren Halbleiterschalter ein Strom mit einer ersten Polarität führen und abschalten und der zweite abschaltbaren Halbleiterschalter ein Strom mit unterschiedlicher Polarität führen und abschalten kann. Eine derartige Parallelschaltung wird auch als Antiparallelschaltung oder eine derartige Anordnung als antiparallel bezeichnet.

Durch die Verwendung dieser zwei abschaltbaren Halbleiterschalter kann auf einfache Weise durch die Verwendung von Standardkomponenten ein Schalter realisiert werden, der Ströme mit unterschiedlichen Polaritäten abschalten kann.

Bei einer weiteren vorteilhaften Ausgestaltung der Erfindung weist der elektronische Schalter einen Schalter und einen Widerstand auf, wobei der Schalter und der Widerstand in einer zweiten Reihenschaltung angeordnet sind, wobei die zweite Reihenschaltung aus dem Schalter und dem Widerstand zum abschaltbaren Halbleiterschalter und zur ersten Reihenschaltung parallel angeordnet ist. Durch die Erweiterung des elektronischen Schalters um einen Schalter und einen Widerstand kann das Wiedereinschalten nach einem abschalten Vorgang besonders verlustarm ausgeführt werden. Die vom Kondensator bei einem Abschaltvorgang aufgenommene Energie aus den Induktivitäten stellt bei einem erneuten Einschalten des Schalters eine Belastung dar, da sich diese Energie beim Einschalten des elektronischen Schalters schlagartig über die abschaltbaren Halbleiterschalter entlädt. Der Entladestrom wird durch die Strom-/Spannungskennlinie des Varistors vorgegeben und kann durchaus beträchtliche Werte annehmen. Dies ist insbesondere dann der Fall, wenn zwischen dem Ausschalten und dem erneuten Einschalten nur eine kurze Zeitspanne liegt. In dieser kurzen Zeitspanne kann sich der Kondensator nur wenig entladen und die gespeicherte Energie führen zu einer Belastung der abschaltbaren Halbleiterschalter. Um diese Belastung durch die Entladeströme zu verringern dient der Widerstand. Durch Einschalten des Schalters wird der Widerstand entladen. Dies geschieht dann, wenn die Spannung des Kondensators einen Wert oberhalb der Auslösespannung des Varistors erreicht. Unterhalb dieser Auslösespannung braucht der Kondensator auch nicht entladen zu werden, da ein Zuschalten über die abschaltbaren Halbleiterschalter ebenfalls keine Entladeströme verursacht.

Darüber hinaus kann der Widerstand genutzt werden, um eine Last, die einen hohen Einschaltstrom verursacht, mit gemäßigten Strömen vorzuladen. Als Beispiel einer derartigen Last ist ein Stromrichter zu nennen, dessen Zwischenkreiskapazität einen hohen Ladestrom verursacht. Solche Lasten werden daher zumeist über einen Vorladewiderstand aufgeladen. Bei der Verwendung des elektronischen Schalters mit einem Schalter und einem Widerstand kann diese Strombegrenzung mit Hilfe des elektronischen Schalters durch den Widerstand vorgenommen werden. Damit kann auf eine separate Vorladeschaltung verzichtet werden. Es entsteht eine Synergie, da mit dem Widerstand zum einen das Einaschalten des Schalters besonders belastungsarm geschieht und gleichzeitig der Last die Möglichkeit bietet, strombegrenzt mit dem Gleichspannungsnetz verbunden zu werden. Dies spart Komponenten und erhöht damit die Zuverlässigkeit und die Wirtschaftlichkeit der DC Energieversorgung, da sich eine solche Anordnung besonders kostengünstig herstellen lässt.

Der Schalter kann dabei kostengünstig als ein mechanischer Schalter realisiert werden, da die Anforderungen an die Schaltgeschwindigkeit gering ist. Ebenso ist es möglich, da eine Ansteuereinheit zum Ansteuern von Halbleiterschaltern bereits vorhanden ist, auch diesen mit Hilfe von Halbleitern auszuführen. Auch diese können dann antiparallel oder antiseriell, je nach Ausführungsform des Halbleiters, ausgeführt sein, so dass diese ein Entladen des Kondensators unabhängig von der Polarität der Spannung sicherstellen. Falls der elektronische Schalter nur zum Abschalten eines Stroms mit einer Polarität vorgesehen ist, so reicht auch bei dem Schalter, diesen nur für eine Polarität vorzusehen, da der Kondensator nur Spannung einer Polarität annehmen kann.

Bei den Halbleitern kann es sich um abschaltbare Halbleiter wie beispielsweise IGBTs oder MOSFETs handeln oder auch um nicht abschaltbare Halbleiter, wie beispielsweise einen Thyristor. Da mit dem Einschalten der abschaltbaren Halbleiterschalter des elektronischen Schalters der Strom durch den Schalter und den Widerstand zum Erliegen kommt, ist die Fähigkeit, einen Strom abschalten zu können, für diese Anwendung nicht erforderlich. Die Verwendung eines Thyristors ist dabei besonders vorteilhaft, da es sich bei den Entladeströmen bzw. Vorladeströme von der Last um kurzzeitig hohe Ströme handelt und der Thyristor ein besonders große Überlastfähigkeit aufweist. Unter Überlastfähigkeit versteht man die kurzzeitige Belastung eines Stroms, die zwar kurzfristig, aber nicht dauerhaft zulässig ist. Somit kann dieser elektronische Schalter, insbesondere bei der Realisierung des Schalters durch Halbleiter bzw. Thyristoren, besonders kostengünstig hergestellt werden.

Das Einschalten des Schalters erfolgt dann vorteilhafterweise vor dem erneuten Zuschalten des abschaltbaren Halbleiterschalters bzw. der abschaltbaren Halbleiterschalter des elektronischen Schalters, so dass zum Zeitpunkt des Einschaltens des abschaltbaren Halbleiterschalters bzw. der abschaltbaren Halbleiterschalter die Spannung am Kondensator hinreichend klein oder sogar null ist. Damit stellen dann die Entladeströme durch den abschaltbaren Halbleiterschalters bzw. die abschaltbaren Halbleiterschalter keine hohe Belastung mehr da, so dass sich für den elektronischen eine höhere Lebensdauer ergibt.

Bei einer weiteren vorteilhaften Ausgestaltung der Erfindung ist parallel zum Kondensator ein Entladewiderstand angeordnet. Der Entladewiderstand stellt sicher, dass sich eine Spannung über den Kondensator kontinuierlich entlädt. Damit kann die entstehende Spannung am Kondensator bei einem Abschaltvorgang des elektronischen Schalters reduziert werden. Man spricht in diesem Zusammenhang von einer deterministischen Entladung des Kondensators. Falls zwischen Abschaltvorgang und erneutem Einschaltvorgang eine hinreichende Zeitspanne liegt, die von der Wahl des Widerstandswertes des Entladewiderstands abhängt, kann auf die Verwendung des Schalters mit Widerstand verzichtet werden. Alternativ ist es möglich, die Schaltung mit Schalter und Widerstand um diesen Entladewiderstand zu erweitern, so dass auch für kurze Zeitspannen zwischen Abschalten und erneutem Einschalten die Funktion des elektronischen Schalters uneingeschränkt zur Verfügung steht. Durch den Entladewiderstand werden somit die Belastungen der abschaltbaren Halbleiterschalter und eines vorhandenen Schalters weiter reduziert, so dass sich die Lebensdauer des Schalters auf einfache Weise weiter erhöht.

Bei einer weiteren vorteilhaften Ausgestaltung der Erfindung ist parallel zum Varistor ein weiterer Kondensator angeordnet. Durch den weiteren Kondensator, dessen Kapazitätswert vorteilhafterweise um mindestens eine Größenordnung kleiner ist als die Kapazität des Kondensators, wird das induktive Ansprechverhalten des Varistors kompensiert und somit eine Überspannung bei der Kommutierung des Stromes von dem abschaltbaren Halbleiterschalter oder den abschaltbaren Halbleiterschaltern auf die erste Reihenschaltung aus Varistor und Kondensator weiter reduziert. Auch dies verringert noch einmal die am abschaltbaren Halbleiterschalter oder den abschaltbaren Halbleiterschaltern entstehende Belastung, die durch dort anliegende Spannung entsteht.

Bei einer weiteren vorteilhaften Ausgestaltung der Erfindung ist parallel zum Varistor ein weiterer Entladewiderstand angeordnet. Wird nun als weitere vorteilhafte Ausgestaltung parallel zum Varistor ein weiterer Entladewiderstand angeordnet, der einen deutlich geringeren Widerstandswert als der Entladewiderstand aufweist, wird somit der Spannungsabfall über dem Varistor im Normalbetrieb, also im Zustand elektronischer Schalter geöffnet, als auch im Zustand elektronischer Schalter geschlossen, weiter deutlich reduziert. Dadurch wird die Lebensdauer des Varistors erhöht, da seine Belastung im Betrieb deutlich abnimmt. Dabei ist vorteilhafterweise der Widerstandswert des Weiteren Entladewiderstandes um mindestens eine Größenordnung kleiner als die des Entladewiderstandes.

Im Zustand elektronischer Schalter geöffnet wird nun der Spannungsabfall über dem Varistor durch den Spannungsteiler von Entladewiderstand und weiterem Entladewiderstand bestimmt, so dass die Wahl des oben genannten Widerstandswertes besonders vorteilhaft ist. Im Zustand elektronischer Schalter geschlossen wird der Kondensator über den Varistor und dem weiteren Entladewiderstand entladen. Dies bietet die Möglichkeit, auf die erste Reihenschaltung zu verzichten und trotzdem ein schnelles erneutes Zuschalten nach einem Abschaltvorgang zu ermöglichen ohne die abschaltbaren Halbleiterschalter unzulässig hoch zu belasten. Ebenso ist es möglich, den elektronischen Schalter mit einer Ordnung aus erster Reihenschaltung um den weiteren Entladewiderstand zu ergänzen, um damit die Belastungen im Betrieb, insbesondere beim erneuten Einschalten des elektronischen Schalters weiter zu verringern.

Bei einer weiteren vorteilhaften Ausgestaltung der Erfindung wird bei Unterschreiten eines Spannungsschwellwertes einer Spannung am Kondensator der Schalter ausgeschaltet. Wenn sichergestellt ist, dass sich die für den abschaltbaren Halbleiterschalters bzw. die abschaltbaren Halbleiterschalter ergebende Belastung durch Entladeströme des Kondensators hinreichend gering ist, kann die Entladung des Kondensators beendet werden. Dies ist dann der Fall, wenn die Spannung am Kondensator einen vorgebbaren Spannungsschwellwert unterschreitet. Damit kann auch wenn der Kondensator noch nicht vollständig entladen ist ein zügiges erneutes Einschalten des Kondensators erreicht werden. Darüber hinaus wird die Zeit, in der die Last noch über den Widerstand mit der DC Quelle verbunden ist, weiter reduziert. Selbst wenn sich hierüber nur Ströme mit geringem Wert ausbilden können, da diese über den Widerstand begrenzt sind, kann es insbesondere bei Vorliegen eines lastseitigen Kurschluss von Vorteil sein, den Stromfluss zwischen DC Quelle und Last möglichst schnell zu unterbinden und damit mögliche Beschädigungen zu vermeiden.

Im Folgenden wird die Erfindung anhand der in den Figuren dargestellten Ausführungsbeispiele näher beschrieben und erläutert. Es zeigen:
- FIG 1: ein DC Netz mit einem elektronischen Schalter und
- FIG 2 bis FIG 4: Ausführungsbeispiele eines elektronischen Schalters mit Überspannungsschutz.

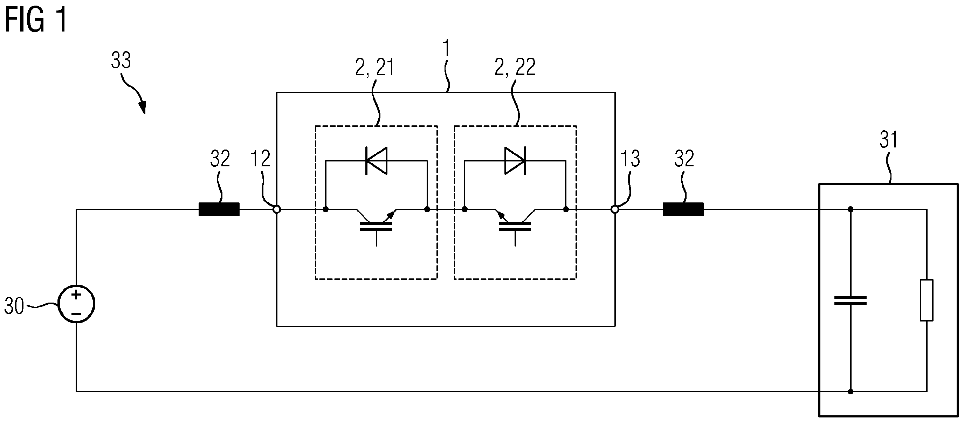

Die FIG 1 zeigt ein DC-Netz 33, das auch als Gleichspannungsnetz bezeichnet wird. Dieses versorgt aus einer DC-Quelle 30, auch als Gleichspannungsquelle bezeichnet, eine Last 31. Bei dieser Last kann es sich beispielsweise um einen Antrieb mit einem Stromrichter handeln, wobei der Stromrichter mit seinem Zwischenkreis mit über einen elektronischen Schalter 1 mit der DC- Quelle 30 verbunden ist. Die Leitungen zwischen DC-Quelle 30 und Last 31 können ganz unterschiedliche Eigenschaften bezüglich ihres induktiven Verhaltens annehmen. Dieses induktive Verhalten ist in der Darstellung mit Hilfe von Induktivitäten 32 dargestellt. Diese können sehr kleine Werte annehmen, da kein Transformator vorhanden ist, der mit seiner Induktivität strombegrenzend wirkt. Auf der anderen Seite können die Induktivitäten auch sehr große Werte aufgrund großer Kabellängen annehmen, die aufgrund der Energieübertragung mit Gleichstrom zulässig sind. Für den elektronischen Schalter ergeben sich daraus die Anforderungen, dass er aufgrund der geringen Induktivität und der damit einhergehenden großen Stromänderungen, insbesondere bei einem Kurzschluss, ein sehr schnelles Schaltverhalten aufweisen sollte, damit unzulässig hohe Ströme, wie sie beispielsweise bei einem Kurzschluss entstehen sicher beherrscht werden können. Darüber hinaus muss der Schalter auch in der Lage sein, bei hohen Induktivitäten sicher zu funktionieren. Dann gibt es zwar kein Problem mit zu großen Stromanstiegen, jedoch verursacht die Induktivität hohe Spannungen, die sich aus der Stromänderung beim Abschalten ergeben. Auch diese müssen sicher beherrscht werden und dürfen den elektronischen Schalter 1 und seine darin befindlichen Komponenten nicht schädigen.

Die FIG 1 zeigt dabei den prinzipiellen Aufbau eines elektronischen Schalters 1. In seinem Leistungspfad zwischen seinem ersten Anschluss 12 und seinem zweiten Anschluss 13 ist mindestens ein abschaltbarer Halbleiterschalter 2 angeordnet der einen Strom durch den Schalter abschalten kann. Je nach Art des abschaltbaren Halbleiterschalters 2 kann dieser einen Strom in nur eine Richtung oder in beiden Richtungen zwischen dem ersten und dem zweiten Anschluss 12, 13 abschalten. Vorteilhaft ist die Verwendung zweier abschaltbarer Halbleiterschalter 2, die jeweils den Strom für eine Richtung ausschalten können. Wenn diese rückwärts sperrend sind, werden sie in einer Antiparallelschaltung angeordnet. Für den Fall, dass die abschaltbaren Leistungshalbleiterschalter rückwärts leitfähig sind, erkennbar an der Diode parallel zum schaltenden Element des abschaltbaren Halbleiterschalters 2, 21, 22, erfolgt die Anordnung, wie in FIG 1 dargestellt, in einer Reihenschaltung, bei der der erste abschaltbare Halbleiterschalter 21 und der zweite abschaltbare Halbleiterschalter 22 der beiden abschaltbaren Halbleiterschalter antiseriell miteinander verbunden sind.

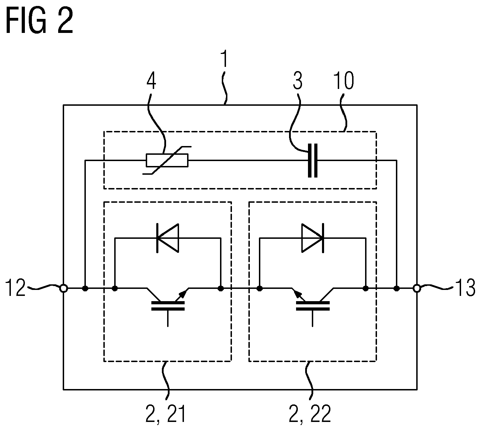

Die FIG 2 zeigt ein Ausführungsbeispiel eines elektronischen Schalters 1 mit einer Überspannungsbegrenzung. Zur Vermeidung von Wiederholungen wird auf die Beschreibung zur FIG 1 sowie auf die dort eingeführten Bezugszeichen verwiesen. Parallel zu dem ersten und zweiten abschaltbaren Halbleiterschalter 21, 22 ist eine erste Reihenschaltung 10 angeordnet. Diese erste Reihenschaltung 10 weist einen Kondensator 3 und einen Varistor 4 auf, die in einer Reihenschaltung angeordnet sind. Schaltet einer der beiden abschaltbaren Halbleiterschalter 21, 22 den Strom zwischen den Anschlüssen 12, 13 des elektronischen Schalters 1 ab, so wird der durch die Induktivitäten getriebene Strom auf die erste Reihenschaltung 10 kommutiert. Aufgrund der entstehenden Spannungen wird der Varistor leitend, auch als Durchbrechen des Varistors bezeichnet, und der Kondensator 3 nimmt die Energie aus den Induktivitäten auf. Dadurch werden die entstehenden Spannungen am Schalter, die sich aus der großen Stromabnahme durch das Abschalten ergeben reduziert und eine Beschädigung des Schalters vermieden. Gleichzeitig erhöht sich die Lebensdauer des Schalters, da die abschaltbaren Halbleiterschalter nicht mit zu hoher Spannung belastet werden.

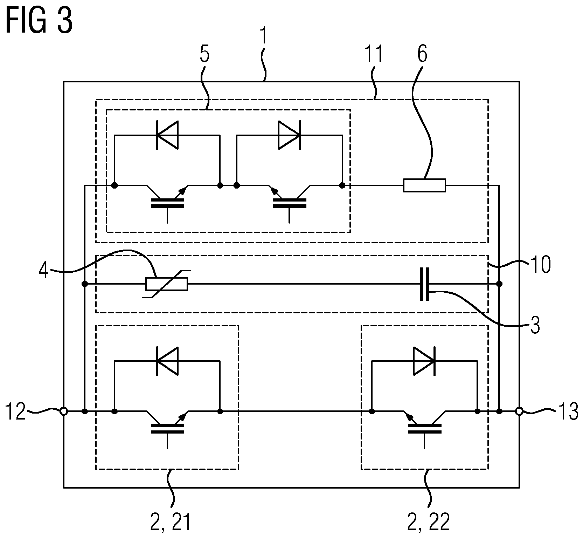

Ein erneutes Einschalten des elektronische Schalters 1 führt zu einem Entladen des Kondensators 3 über die abschaltbaren Halbleiterschalter 2, 21, 22. Dies ist insbesondere dann der Fall, wenn die Zeitspanne zwischen Abschalten und erneutem Zuschalten des elektronischen Schalters derart gering ist, dass eine Selbstentladung des Kondensators noch nicht oder nicht hinreichend stattfinden konnte. Um dieses zu vermeiden ist im Ausführungsbeispiel des elektronischen Schalters 1 in FIG 3 eine zweite Reihenschaltung 11 aus Schalter 5 und Widerstand 6 eingefügt, die parallel zur ersten Reihenschaltung angeordnet ist. Zur Vermeidung von Wiederholungen wird auf die Beschreibung zu den Figuren 1 und 2 sowie auf die dort eingeführten Bezugszeichen verwiesen. Mit dieser zweiten Reihenschaltung 11 kann der Kondensator 3 durch Schließen des Schalters 5 entladen werden bevor die abschaltbaren Halbleiterschalter 2, 21, 22 erneut eingeschaltet werden. Gleichzeitig kann dieser Widerstand 6 als Vorladewiderstand für eine Last 31 verwendet, die aufgrund von hohen Einschaltströmen üblicherweise über einen Vorladewiderstand mit der DC Quelle verbunden wird. Als Beispiel einer derartigen Last ist ein Stromrichter zu nennen, dessen Zwischenkreiskondensator üblicherweise über einen Vorladewiderstand aufgeladen wird.

Der Schalter kann dabei als mechanischer Schalter oder mit Hilfe eines Halbleiters realisiert werden. Dabei können sowohl abschaltbare Halbleiter oder auch nichtabschaltbare Halbleiter wie Thyristoren zum Einsatz kommen.

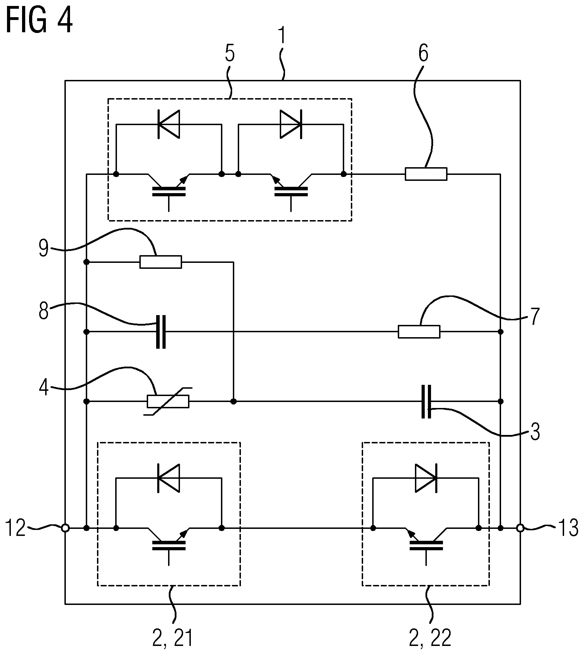

Im Ausführungsbeispiel der FIG 4 sind weitere Maßnahmen zur Spannungsbegrenzung aufgezeigt, die sowohl einzeln oder auch in Ihrer Gesamtheit zum Einsatz kommen können. Zur Vermeidung von Wiederholungen wird auf die Beschreibung zu den Figuren 1 bis 3 sowie auf die dort eingeführten Bezugszeichen verwiesen. Als erste Maßnahme kann dabei parallel zum Kondensator 3 ein Entladewiderstand 7 angeordnet werden. Dieser stellt sicher, dass nach Abschalten des elektronischen Schalters 1 der Kondensator 3, der die Energie aus den Induktivitäten 32 aufgenommen hat, zügig wieder entladen wird und ein erneutes Zuschalten auch ohne vorheriges Zuschalten des Widerstandes 6 erfolgen kann.

Als zweite Maßnahme ist die Anordnung eines weiteren Kondensators 8 parallel zum Varistor 4. Dieser verbessert das induktive Ansprechverhalten des Varistors 4 bei der Kommutierung des Stroms von den abschaltbaren Halbleiterschaltern auf den Strompfad durch den Kondensator 3. Somit können auch kurzfristige Spannungsspitzen an den abschaltbaren Halbleiterschaltern vermieden werden. Auch dies wirkt sich positiv auf die Lebensdauer des elektronischen Schalters 1 aus.

Als dritte Maßnahme kann ein weiterer Entladewiderstand 9 parallel zum Varistor 4 angeordnet werden. Durch den sich ergebenen Spannungsteiler aus Entladewiderstand 7 und weiterem Entladewiderstand 9 verringert sich der Spannungsabfall über den Varistor 4. Dies geschieht sowohl bei eingeschaltetem wie auch bei ausgeschaltetem elektronischen Schalter 1 und erhöht die Lebensdauer des Varistors 4 und damit auch des elektronischen Schalters 1. Gleichzeitig ermöglicht der weitere Entladewiderstand 9 die gemäßigte Entladung des Kondensators 3 bei erneutem Einschalten des elektronischen Schalters 1. Dadurch kann auch die zweite Reihenschaltung 11 verzichtet werden. Bei Verwendung mit der zweiten Reihenschaltung 11 kann die Spannungsbelastung des elektronischen Schalters 1 beim Schalten weiter verringert und dadurch seine Lebensdauer weiter erhöht werden.

Diese drei Maßnahmen können dabei separat oder auch in beliebiger Kombination vorgenommen werden, um das Schaltverhalten des elektronischen Schalters 1 zu verbessern.

Zusammenfassend betrifft die Erfindung einen elektronischen Schalter mit mindestens einem abschaltbaren Halbleiterschalter. Zur Verbesserung des elektronischen Schalters, insbesondere bezüglich seines Abschaltverhaltens, wird vorgeschlagen, dass der elektronische Schalter einen Kondensator und einen Varistor aufweist, wobei der Kondensator und der Varistor in einer ersten Reihenschaltung angeordnet sind, wobei die erste Reihenschaltung aus dem Kondensator und dem Varistor parallel zum abschaltbaren Halbleiterschalter angeordnet ist. Weiter betrifft die Erfindung ein Verfahren zum Betreiben eines derartigen elektronischen Schalters mit einem Schalter und einem Widerstand, wobei vor dem Einschalten des abschaltbaren Halbleiterschalters der Schalter eingeschaltet wird.

## Patentansprüche

1. Elektronischer Schalter (1), aufweisend
- mindestens einen abschaltbaren Halbleiterschalter (2,21,22)
- einen Kondensator (3) und
- einen Varistor (4),
wobei der Kondensator (3) und der Varistor (4) in einer ersten Reihenschaltung (10) angeordnet sind, wobei die erste Reihenschaltung (10) aus dem Kondensator (3) und dem Varistor (4) parallel zum abschaltbaren Halbleiterschalter (2,21,22) angeordnet ist.

2. Elektronischer Schalter (1) nach Anspruch 1, wobei der elektronische Schalter (1) mindestens zwei abschaltbare Halbleiterschalter (2) aufweist, wobei ein erster (21) der zwei abschaltbaren Halbleiterschalter (2,21,22) derart angeordnet ist, einen Strom von einem ersten Anschluss (12) des elektronischen Schalters (1) zu einem zweiten Anschluss (13) des elektronischen Schalters (1) abschalten zu können und ein zweiter (22) der zwei abschaltbaren Halbleiterschalter (2) derart angeordnet ist, einen Strom von dem zweiten Anschluss (13) des elektronischen Schalters (1) zu dem ersten Anschluss (12) des elektronischen Schalters (1) abschalten zu können, wobei der Kondensator (3) als bipolarer Kondensator (3) ausgebildet ist.

3. Elektronsicher Schalter (1) nach einem der Ansprüche 1 oder 2, wobei der elektronische Schalter (1) einen Schalter (5) und einen Widerstand (6) aufweist, wobei der Schalter (5) und der Widerstand (6) in einer zweiten Reihenschaltung (11) angeordnet sind, wobei die zweite Reihenschaltung (11) aus dem Schalter (5) und dem Widerstand (6) zum abschaltbaren Halbleiterschalter (2,21,22) und zur ersten Reihenschaltung (10) parallel angeordnet ist.

4. Elektronsicher Schalter (1) nach einem der Ansprüche 1 bis 3, wobei parallel zum Kondensator (3) ein Entladewiderstand angeordnet (7) ist.

5. Elektronsicher Schalter (1) nach einem der Ansprüche 1 bis 4, wobei parallel zum Varistor (4) ein weiterer Kondensator (8) angeordnet ist.

6. Elektronsicher Schalter (1) nach einem der Ansprüche 1 bis 5, wobei parallel zum Varistor (4) ein weiterer Entladewiderstand (9) angeordnet ist.

7. Verfahren zum Betreiben eines elektronischen Schalters (1) nach einem der Ansprüche 3 bis 5 mit einem Schalter (5) und einem Widerstand (6) gemäß Anspruch 3, wobei vor dem Einschalten des abschaltbaren Halbleiterschalters (2,21,22) der Schalter (5) eingeschaltet wird.

8. Verfahren nach Anspruch 7, wobei bei Unterschreiten eines Spannungsschwellwertes einer Spannung am Kondensator (3) der Schalter (5) ausgeschaltet wird.
